# EUROPEAN PATENT SPECIFICATION

(11) **EP 0 605 946 B1**
(45) Date of publication and mention of the grant of the patent: **24.02.1999**
(21) Application number: 93308354.5
(22) Date of filing: 20.10.1993
(51) Int. Cl.: H01L 21/331, H01L 29/10, H01L 21/76

(54) **Transistor process for removing narrow base effects**
Schmale Basis-Effekte vermeidendes Verfahren für einen Transistor
Procédé pour un transistor remédiant aux effets de base étroite

(30) Priority: 12.11.1992 US 974769
(43) Date of publication of application: 13.07.1994
(73) Proprietor: NATIONAL SEMICONDUCTOR CORPORATION, Santa Clara, California 95052-8090 (US)
(72) Inventor: Farrenkopf, Doug R., Santa Clara, California 95051 (US)
(74) Representative: Bowles, Sharon Margaret

(56) References cited:
- EP-A- 0 054 649
- EP-A- 0 070 499
- FR-A- 2 396 411
- US-A- 4 441 932

## Description

### Background of the Invention

In field oxide masked ion-implanted transistors a relatively thick field oxide is photolithographically formed using a nitride mask to define the active transistor regions. This oxide can be employed as a precision ion implant mask to localize the transistor emitter and base regions in high performance PN junction isolated NPN transistor structures. Such a process allows subsequent use of photolithographic resist masking from ion implants that does not require high precision. The following description relates to the prior art method of forming NPN transistors.

### Description of the Prior Art

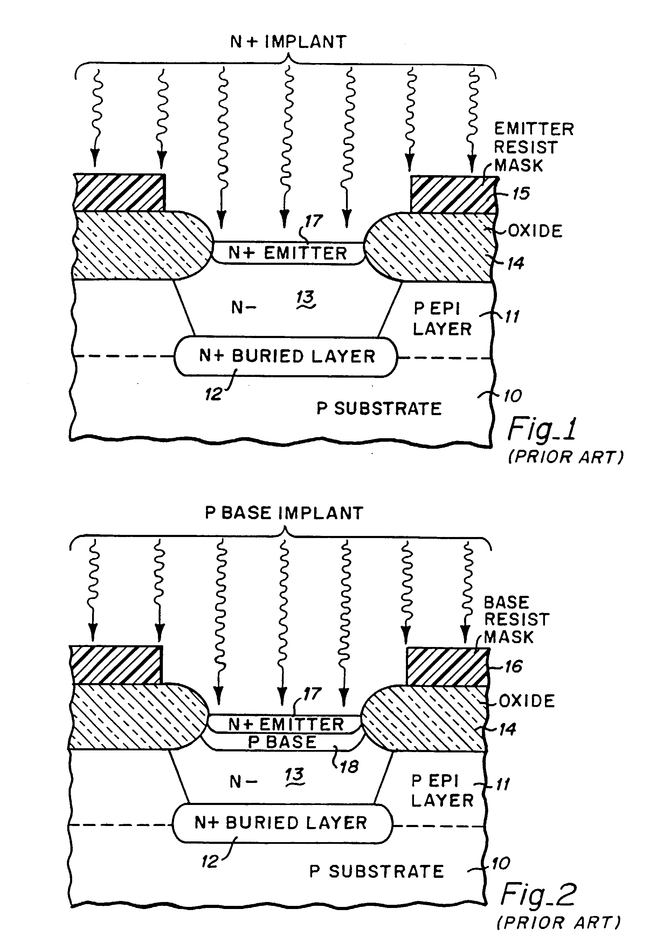

Figure 1 shows a cross section of an NPN transistor that is processed on a silicon wafer. A P type substrate 10 is employed and a P type epitaxial layer 11 is deposited thereon. A conventional N+ buried layer 12 is produced at the substrate-to-epitaxial layer interface. An N well 13 is created conventionally to provide the desired conductivity for the transistor collector region. A conventional relatively thick field oxide 14 is grown on the wafer surface except where the active transistor is to be created. Oxide 14 is prevented from growing in the emitter region by means of a conventional silicon nitride mask photolithographically applied in accordance with the well known local oxidation processing of silicon. An implant mask 15 composed of photoresist is applied over the wafer. Mask 15 has an opening which is only approximately in registry with emitter region 17. The precise emitter masking is provided by oxide Mask 15 is required to define the emitter region on the wafer surface as will be shown subsequently.

Using an emitter mask 15, emitter region 17 is created by ion implanting a suitable N type impurity with the total dose providing the desired doping level. Then, as shown in Figure 2, a suitable P type impurity is ion implanted using base mask 16, to create base region layer 18. Mask 16 defines the transistor base region on the wafer as will be shown subsequently. The base implant dose is set to provide the desired base doping level. The P type base impurity is implanted at an energy which is high enough so that it extends deeper into the silicon than the N type emitter. Therefore, it extends laterally under the oxide to a greater extent as shown. Typically, after ion implanting is completed all resist is removed and the semiconductor wafer is subjected to a high temperature anneal which activates the ion implanted impurities and produces a certain amount of thermal impurity diffusion.

It can be seen in figure 2 that base layer 18 is relatively uniform in thickness over its width. However, at the extreme edges, which represent the emitter periphery, this thickness is reduced. It has been found that this reduced thickness is a function of oxide 14 slope at the emitter edge. Thus, this thinning is a function of the fabrication process and is a variable. The result is a process-determined variation in transistor BETA and BV_{CEO} (the collector-emitter reverse breakdown voltage with the base open-circuited.) It would be desirable to remove the process-determined variables associated with the thin base at the emitter periphery.

EP-A-0070499 shows a process in which an etched edge of a field oxide is used as a self-aligning edge for both a base and subsequent emitter implantation.

### Summary of the Invention

It is an object of the invention to eliminate the thin base on the periphery of an ion implanted NPN transistor so that the transistor characteristics are determined by the part of the base directly under the emitter.

According to the invention there is provided a process for fabricating NPN transistors in a silicon wafer utilizing a field oxide as a defining edge for implantation of emitter and base impurities, characterised in that the emitter implantation is performed first with the field oxide acting as the defining edge for the emitter implantation and the field oxide is then etched back to define a wider opening for the subsequent base implantation.

### Brief Description of the Drawing

Figure 1 is a prior art showing in cross section of a semiconductor wafer fragment into which an NPN transistor is to be fabricated showing the detail of the emitter formation.

Figure 2 is a prior art showing of the figure 1 structure after base fabrication.

Figure 3 is a semiconductor wafer fragment cross section showing the base implant after the invention step of etching the oxide following emitter formation as portrayed in figure 1.

Figure 4 is a semiconductor wafer fragment showing the surface structure of the transistor of figure 3.

### Description of the Invention

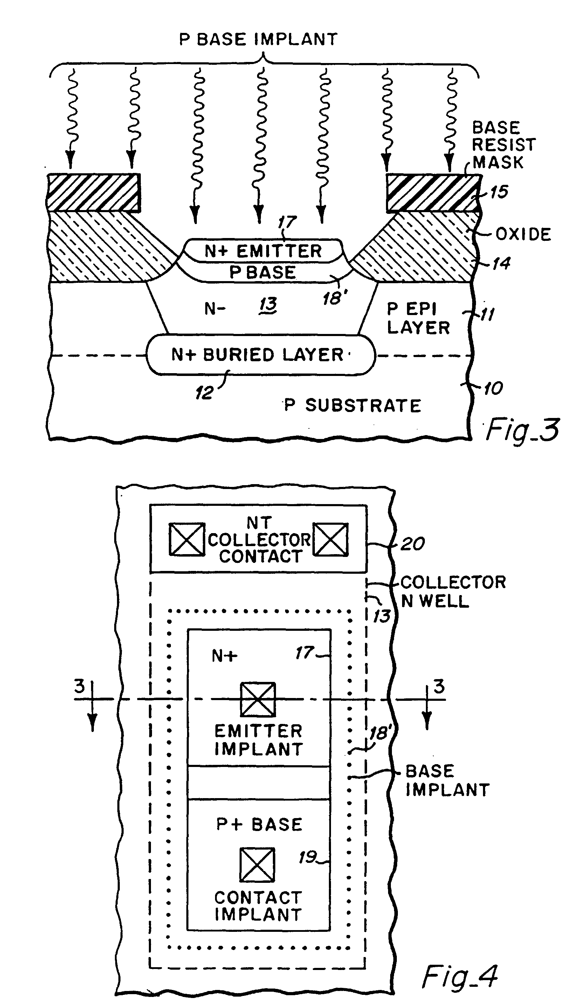

In practicing the invention, the first step is an emitter impurity ion implant as shown in prior art figure 1. After the emitter ion implant, mask 15 is removed and base mask 16 applied as shown in figure 2. Then the semiconductor wafer is subjected to an oxide-selective etch to produce the oxide structure of figure 3. This etch can be an immersion step in a hydrofluoric acid/H20 mixture which selectively removes the exposed oxide. It can be seen that field oxide 14 has been isotropically etched back at the periphery of the emitter region. Then, when the base implant is performed, to create the base region 18' this region will extend further around emitter 17 as shown. This eliminates the peripheral thin base evident in figure 2.

Figure 4 shows a surface view of the resulting transistor. Dashed line 13 represents the N type collector well. Dotted line 18' represents the P type base region after ion implant and anneal/diffusion. Square 17 represents the emitter and square 19 represents a P+ extrinsic base diffusion contact. Rectangle 20 is an N+ diffused collector contact. The squares with an X therein represents an ohmic contact between a metallization layer (not shown) and the transistor elements. It can clearly be seen that the transistor base 18' extends around and beyond emitter 17.

NPN transistors were fabricated by the process as described above and illustrated in figures 1, 3 and 4. The resulting NPN transistors displayed consistent values of Beta. In samples produced, as described above, the Beta was typically on the order of 75. These transistors had BV_{CEO} values consistently above 8 volts.

It is to be understood that while the above-described process involves the fabrication of N well collector NPN transistors located in a P type epitaxial layer deposited onto a P type substrate wafer, the invention could be applied to any NPN transistors created by sequential emitter and base ion implants.

## Claims

1. A process for fabricating NPN transistors in a silicon wafer utilizing a field oxide (14) as a defining edge for implantation of emitter (17) and base (18) impurities, characterised in that the emitter implantation is performed first with the field oxide acting as the defining edge for the emitter implantation and the field oxide is then etched back to define a wider opening for the subsequent base implantation.

2. A process according to claim 1 in which the field oxide is etched back isotropically.

3. A process according to claim 2 in which the field oxide is etched beyond the periphery of the emitter implantation.

## Patentansprüche

1. Verfahren zum Herstellen von NPN-Transistoren in einem Siliziumwafer unter Einsatz eines Feldoxids (14) als Begrenzungskante für die Implantation von Emitter-(17) und Basisverunreinigungen (18),
dadurch **gekennzeichnet,** daß die Emitter-Implantation zunächst mit dem Feldoxid als Begrenzungskante für die Emitter-Implantation durchgeführt wird und das Feldoxid dann zurückgeätzt wird, um eine weitere Öffnung für die nachfolgende Basisimplantation zu begrenzen.

2. Verfahren nach Anspruch 1,
wobei das Feldoxid isotrop zurückgeätzt wird.

3. Verfahren nach Anspruch 2,
wobei das Feldoxid über die Peripherie der Emitter-Implantation geätzt wird.

## Revendications

1. Procédé pour fabriquer des transistors NPN dans une plaquette de silicium utilisant un oxyde primaire (14) comme bord de définition pour l'implantation d'impuretés d'émetteur (17) et de base (18), caractérisé en ce que l'implantation de l'émetteur est effectuée tout d'abord avec l'oxyde primaire qui joue le rôle de bord de définition pour l'implantation de l'émetteur, après quoi l'oxyde primaire est ensuite regravé pour définir une ouverture plus large pour l'implantation de base ultérieure.

2. Procédé selon la revendication 1, dans lequel l'oxyde primaire est regravé de façon isotrope.

3. Procédé selon la revendication 2, dans lequel l'oxyde primaire est gravé au-delà de la périphérie de l'implantation de l'émetteur.
